# EUROPEAN PATENT APPLICATION

(11) **EP 1 724 833 A2**
(43) Date of publication of application: **22.11.2006**
(21) Application number: 06010256.3
(22) Date of filing: 18.05.2006
(51) Int. Cl.: H01L 23/66, H01L 25/16, H05K 1/11, H01L 23/31, H01L 23/14

(54) **SIP (system-in-package) type package containing analog semiconductor chip and digital semiconductor chip stacked in order, and method for manufacturing the same**

(30) Priority: 20.05.2005 JP 2005147831
(71) Applicant: NEC Electronics Corporation, Kawasaki, Kanagawa 211-8668 (JP)
(72) Inventor: Kikushima, Kimihiro, Nakahara-ku Kawasaki Kanagawa 211-8668 (JP)
(74) Representative: Glawe, Delfs, Moll

(57) **Abstract**

In a semiconductor package, a wiring board (40) having a ground layer (42₃, 54) is formed therein. An analog semiconductor chip (47, 53) is provided on or above the ground layer, and a digital semiconductor chip (50) is provided on or above the analog semiconductor chip such that a substrate (50A) of the digital semiconductor chip is directed toward the analog semiconductor chip.

## Description

### BACKGROUND OF THE INVENTION

### Field of the Invention

The present invention relates to a system-in-package type (SIP) package containing an analog semiconductor device and a digital semiconductor device, which may be advantageously used to receive and process a radio frequency (RF) signal in, for example, a global positioning system (GPS), and also relates to a method for manufacturing such a SIP package.

### Description of the Related Art

In a GPS-signal receiver apparatus, both a radio frequency (RF) signal processing unit and a baseband signal processing unit are required to receive and process a GPS signal. Namely, in the RF signal processing unit, the GPS signal is down-converted into an intermediate frequency signal, and then the intermediate frequency signal is demodulated to thereby generate an analog baseband signal. The analog baseband signal is converted into a digital baseband signal, and then the digital baseband signal is output to the baseband processing unit. Next, in the baseband signal processing unit, the digital baseband signal is further processed to thereby generate a GPS position information signal.

The RF signal processing unit is formed as an analog semiconductor package, and the baseband signal processing unit is formed as a digital semiconductor package. These semiconductor packages are mounted on a wiring board of the GPS-signal receiver apparatus, and other various units are also mounted on the wiring board.

Thus, the GPS-signal receiver apparatus is a large size and bulky, and is unsuitable for use in a small piece of electronic equipment, such as a mobile phone terminal, a personal digital assistant (PDA) or the like.

JP-2004-214249-A discloses a prior art semiconductor package containing two digital semiconductor chips, one of which is arranged above the other semiconductor chip. Thus, in the above-mentioned GPS-signal receiver apparatus, if both the analog semiconductor chip contained in the RF signal processing unit and the digital semiconductor chip contained in the baseband signal processing unit are constituted as one package, this package may contribute to downsizing of the wiring board of the GPS-signal receiver apparatus.

JP-2002-033439-A discloses another prior art semiconductor package containing both an analog RF signal processing semiconductor chip and a digital baseband signal processing semiconductor chip, with the former being arranged above the latter. This package may also contribute to downsizing of the wiring board of the GPS-signal receiver apparatus.

### SUMMARY OF THE INVENTION

It has now been discovered that the above-mentioned prior arts have a problem to be solved as mentioned hereinbelow.

The above-mentioned prior arts cannot sufficiently contribute to the downsizing of the wiring board of the GPS-signal receiver apparatus, in that various units, such as a band pass filter unit, an impedance matching circuit and so on must be further mounted on the wiring board GPS-signal receiver apparatus.

Also, in the prior art disclosed in JP-2002-033439-A, the analog RF signal processing semiconductor chip is susceptible to high frequency noises, especially generated from the digital baseband signal processing semiconductor chip.

In accordance with a first aspect of the present invention, there is provided a semiconductor package, which includes a wiring board having a ground layer formed therein, an analog semiconductor chip provided on or above the ground layer, and a digital semiconductor chip provided on or above the analog semiconductor chip such that a substrate of the digital semiconductor chip is directed toward the analog semiconductor chip.

The analog semiconductor chip may be formed as a radio frequency signal processing semiconductor chip, and the digital semiconductor chip may be formed as a baseband signal processing semiconductor chip. Preferably, the ground layer is coextended with respect to the analog semiconductor chip.

In this semiconductor package, an active layer of the analog semiconductor chip may be directed toward an upside, but an active layer of the digital semiconductor chip is directed toward the upside. In this case, the analog semiconductor chip and the digital semiconductor chip are connected to a wiring pattern layer, formed on the wiring board, with a plurality of conductive wires.

On the other hand, an active layer of the analog semiconductor chip may be directed toward a downside, but an active layer of the digital semiconductor chip is directed toward an upside. In this case, the digital semiconductor chip is mounted on a substrate of the analog semiconductor chip. Also, the analog semiconductor chip has a plurality of metal bumps provided on the active layer thereof, and is connected to a wiring pattern layer, formed on the wiring board, with the metal bumps. Further, the digital semiconductor chip are connected to the wiring pattern layer with a plurality of conductive wires.

Preferably, the digital semiconductor chip features a wider size than that of the analog semiconductor chip.

The semiconductor package may further include a spacer unit provided between the analog semiconductor chip and the digital semiconductor chip.

The semiconductor package may further include an impedance matching circuit provided on the wiring board for the analog semiconductor, and a molded resin enveloper encapsulating the analog and digital semiconductor chips and the impedance matching circuit.

The semiconductor package may further include a band pass filter provided on the wiring board for the analog semiconductor chip, and a molded resin enveloper encapsulating the analog and digital semiconductor chips and the band pass filter.

The semiconductor package may further includes a plurality of metal balls securely attached as electrode terminals to respective electrode pads formed on a bottom surface of the wiring board.

Preferably, the wiring board may be formed as a multi-layered wiring board including at least a lowermost insulating layer, an intermediate insulating layer, and an uppermost insulating layer.

In the semiconductor package, when the active layer of the analog semiconductor chip is directed toward the upside, and when the active layer of the digital semiconductor chip is directed toward the upside, the ground layer is formed in the uppermost insulating layer so that the analog semiconductor chip is positioned on the ground layer.

On the other hand, when the active layer of the analog semiconductor chip is directed toward the downside, and when an active layer of the digital semiconductor chip is directed toward the upside, the ground layer is formed in the intermediate insulating layer just below the uppermost insulating layer so that the analog semiconductor chip is positioned above the ground layer.

In accordance with a second aspect of the present invention, there is provided a method for manufacturing a semiconductor package comprising: preparing a wiring board; forming a ground layer in the wiring board; providing an analog semiconductor chip on or above the ground layer; and providing a digital semiconductor chip on or above the analog semiconductor chip such that a substrate of the digital semiconductor chip is directed toward the analog semiconductor chip.

### BRIEF DESCRIPTION OF THE DRAWINGS

The present invention will be more clearly understood from the description set forth below, with reference to the accompanying drawings, wherein:
Figure 1A is a block circuit diagram of a prior art GPS-signal receiver apparatus;
Figure 1B is a block circuit diagram of the RF signal processing unit of Fig. 1A;
Figure 2 is a partial cross-sectional view of a prior art semiconductor package;
Figure 3A is a cross-sectional view of another prior art semiconductor package;
Figure 3B is a partial perspective view of Fig. 3A;
Figures 4A through 8A are plan views for explaining a method for manufacturing an embodiment of a SIP type package according to the present invention;
Figures 4B through 8B are cross-sectional views taken along the B-B lines of Figs. 4A through 8A, respectively; and
Figure 9 is a cross-sectional view showing a modification of the embodiment of the SIP type package of Figs. 8A and 8B.

### DESCRIPTION OF THE PREFERRED EMBODIMENT

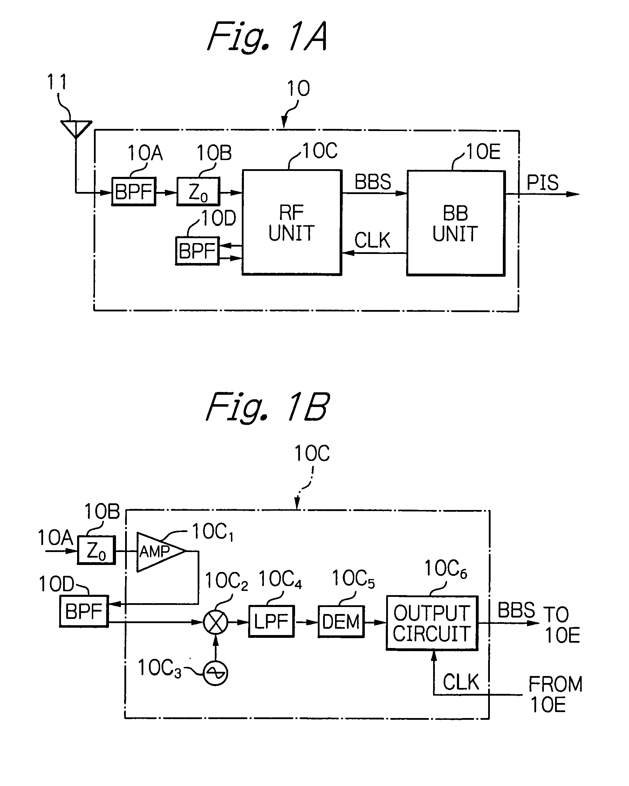

Before the description of the preferred embodiments of the present invention, for better understanding of the present invention, a prior art GPS-signal receiver apparatus will be now explained with reference to Figs. 1A and 1B.

First, referring to Fig. 1A, the GPS-signal receiver apparatus, generally indicated by reference numeral 10, is illustrated in a block diagram. The GPS-signal receiver apparatus 10 includes a band pass filter unit 10A, an impedance matching circuit unit 10B, an RF signal processing unit 10C, a band pass filter unit 10D and a baseband signal processing unit 10E. Note that these units 10A through 10E are mounted on a suitable wiring board (not shown). The band pass filter unit 10A is connected to a GPS antenna 11 at an input terminal thereof for receiving a GPS signal. The RF signal processing unit 10C is constituted as an analog semiconductor package containing an analog RF signal processing semiconductor chip, and the baseband signal processing unit 10E is constituted as a digital semiconductor package containing a digital baseband signal processing semiconductor chip. Note, in Fig. 1A, the impedance matching circuit unit 10B is symbolically represented by a characteristic impedance Z₀.

In operation, the GPS antenna 11 receives a GPS-signal having a frequency of 1575.42 MHz, and the GPS signal is transmitted to the band pass filter 10A in which noises are filtered out of the GPS signal, and then the GPS signal is input to the RF signal processing unit 10C through the impedance matching circuit unit 10B. In the RF signal processing unit 10C, the GPS signal is once amplified, and the amplified GPS signal is output to the band pass filter 10D in which the amplified noises are filtered out of the GPS signal.

Subsequently, the GPS signal is again input to the RF signal processing unit 10C in which the GPS signal (1575.42 MHz) is down-converted into an intermediate frequency signal, having a frequency falling within a range from several MHz to several tens of MHz, and the intermediate frequency signal is demodulated into an analog baseband signal. Then, the analog baseband signal is converted into a digital baseband signal BBS in accordance with a clock signal CLK output from the baseband signal processing unit 10E. Next, the digital baseband signal BBS is output from the RF signal processing unit 10C to the baseband signal processing unit 10E.

In the digital semiconductor package or baseband signal processing unit 10E, the baseband signal BBS is suitably processed to thereby generate a GPS position information signal PIS, and the signal PIS is output from the baseband signal processing unit 10E.

As shown in Fig. 1B, the analog semiconductor package or RF signal processing unit 10C contains an amplifier 10C₁, a mixer 10C₂, a local oscillator 10C₃, a low pass filter 10C₄, a demodulator 10C₅, and an output circuit 10C₆. Note, the output circuit 10C₆ has a sample hold circuit, an analog-to-digital converter, a frequency divider and so on, and is operated in accordance with the clock signal CLK output from the baseband signal processing unit 10E.

In the RF signal processing unit 10C, the aforesaid amplification of the GPS signal is carried out by the amplifier 10C₁. Both the mixer 10C₂ and the local oscillator 10C₃ serves as a down-converter for converting the GPS signal (1575.42 MHz) into the intermediate frequency signal (several MHz to several tens of MHz). Namely, the mixer 10C₂ mixes the GPS signal with a local frequency signal, output from the local oscillator 10C₃, to thereby generate the intermediate frequency signal, which is input to the low pass filter 10C₄ in which noises are filtered out of the intermediate frequency signal.

Then, the aforesaid demodulation of the intermediate frequency into the analog baseband signal is carried out by the demodulator 10C₅, and the aforesaid conversion of the analog baseband signal into the digital baseband signal is carried out by the output circuit 10C₆.

In particular, the clock signal CLK, which is input from the baseband signal processing unit 10E, is divided by the frequency divider circuit into a clock signal having a lower frequency than that of the clock signal CLK. The analog baseband signal is sampled by the sample hold circuit in accordance with the clock signal having the lower frequency, and the sampled signal is converted into the digital baseband signal BBS in accordance with the clock pulses CLK.

The above-mentioned GPS-signal receiver apparatus is constructed as a large-sized apparatus in that the various units 10A through 10E are mounted on the wiring board, and thus is unsuitable for use in a small piece of electronic equipment, such as a mobile phone terminal, a personal digital assistant (PDA) or the like. In particular, when the GPS-signal receiver apparatus is mounted on a motherboard for the small piece of electronic equipment, a mounting area on the motherboard, which is occupied by the wiring board of the GPS-signal receiver apparatus, is considerably large.

Also, in the prior art of Figs. 1A and 1B, when a plurality of GPS-signal receiver apparatuses 10 are produced, it is necessary to individually adjust the impedance matching units 10B, resulting in an increase in production cost for the GPS-signal receiver apparatuses 10.

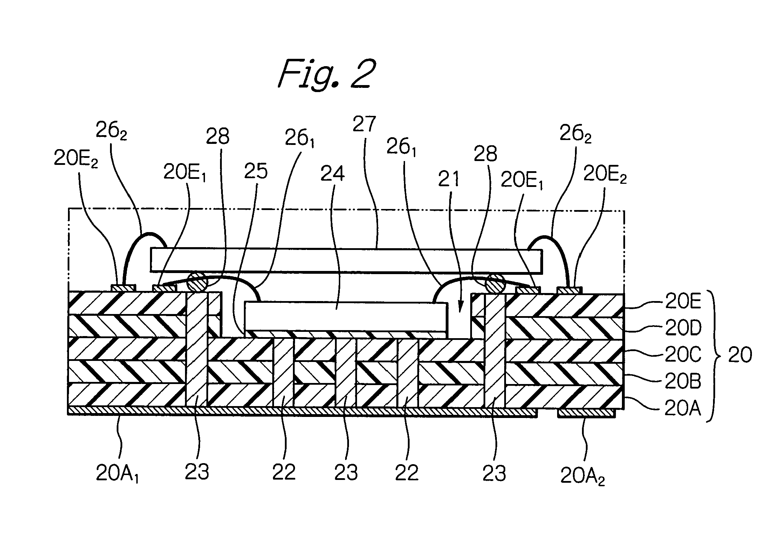

With reference to Fig. 2, a part of a prior art semiconductor package is illustrated in a cross-sectional view, and this prior art semiconductor package is disclosed in, for example, JP-2004-214249-A.

The semiconductor package includes a multi-layered wiring board 20 having a plurality of insulating layers 20A, 20B, 20C, 20D and 20E, which are stacked in order. Each of the insulating layers 20A through 20E has a wiring pattern layer (not shown) formed thereon, and has a plurality of through holes (not shown) formed therein to thereby establish electrical connections between the two adjacent wiring pattern layers.

In the multi-layered wiring board 20, the lowermost insulating layer 20A has a ground layer 20A₁ formed on a bottom surface thereof, with the ground layer 20A₁ serving as a heat radiation layer 20A₁. Also, the lowermost insulating layer 20A has a plurality of electrode pads 20A₂ formed on the bottom surface thereof. Note, in Fig. 2, only one of the el ectrode terminals 22 is representatively illustrated.

On the other hand, the uppermost insulating layer 20E has a plurality of electrode pads 20E₁ and a plurality of electrode pads 20E₂, which are formed on a top surface thereof, and each of the electrode pads is connected to the wiring pattern layer formed on the top surface of the uppermost insulating layer 20E. Note, the wiring pattern layer formed on the uppermost insulating layer 20E is connected to the electrode pads 20A₂ through the intermediary of the through holes and the wiring pattern layers intervened therebetween.

As shown in Fig. 2, the multi-layered wiring board 20 has a rectangular recess 21 which is formed in both the insulating layers 20D and 20E above the ground layer or heat radiation layer 20A₁. A plurality of metal plugs 22 are formed in the insulating layers 20A, 20B and 20C at a bottom of the rectangular recess 21 so as to reach the heat radiation layer 20A₁. Also, a plurality of metal plugs 23 are formed in the insulating layers 20A, 20B, 20C, 20D and 20E so as to reach the heat radiation layer 20A₁, and are arranged to surround the rectangular recess 21.

The semiconductor package also includes a digital semiconductor chip 24 which is mounted on and adhered to the bottom of the rectangular recess 21 with an adhesive layer 25, and the digital semiconductor chip 24 is connected to the electrode pads 20E₁ with bonding wires 26₁. The digital semiconductor chip 24 is thermally connected to the heat radiation layer 20A₁ through the metal plugs 22, and thus it is possible to facilitate radiation of heat from the digital semiconductor chip 24.

The semiconductor package further includes a digital semiconductor chip 27 which is mounted on and secured to a plurality of metal support balls 28 fixed on respective top faces of the metal plugs 23, and the digital semiconductor chip 27 is connected to the electrode pads 20E₂ with bonding wires 26₂. The digital semiconductor chip 27 also is thermally connected to the heat radiation layer 20A₁ through the metal plugs 26, and thus it is possible to facilitate radiation of heat from the digital semiconductor chip 27.

After the mounting of the semiconductor chips 24 and 27 is completed, these chips 24 and 25 are sealed together with the wiring pattern layer, the electrode pads 20E₁ and 20E₂ and the bonding wires 26₁ and 26₂ with a molded resin enveloper 29, only a contour of which is shown by a phantom line in Fig. 2 for simplicity of illustration.

As shown in Fig. 2, the semiconductor chip 27 is arranged above the semiconductor chip 24 in the molded resin enveloper 29. Thus, when the semiconductor package is mounted on a motherboard, a mounting area on the motherboard, which is occupied by the wiring board of the GPS-signal receiver apparatus, is relatively small.

Accordingly, in the prior art of Figs. 1A and 1B, if both the analog RF signal processing semiconductor chip contained in the RF unit 10C and the digital semiconductor chip contained in the baseband signal processing unit 10E are constituted as one package, as shown in Fig. 2, this package may contribute to downsizing of the wiring board of the GPS-signal receiver apparatus 10.

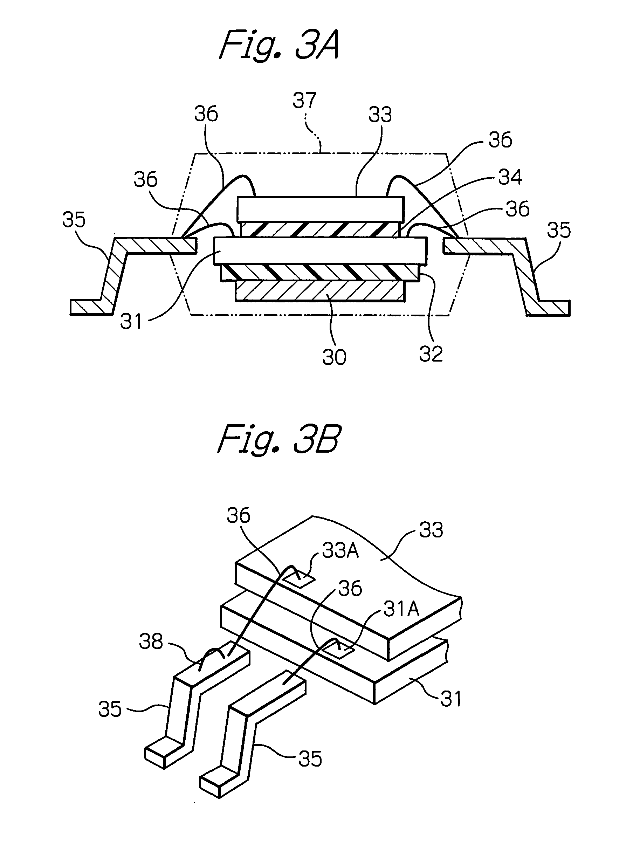

With reference to Figs. 3A and 3B, another prior art semiconductor package, which is of quad flat package (QFP) type, is illustrated, and this QFP type semiconductor package is disclosed in, for example, JP-2002-033439-A. Note, Fig. 3A is a cross-sectional view of the QFP type semiconductor package, and Fig. 3B is a partial perspective view of Fig. 3A.

Referring to Fig. 3A, the QFP type semiconductor package includes an island or mount plate 30, a digital baseband signal processing semiconductor chip 31 mounted on and adhered to the mount plate 30 with an adhesive layer 32, an analog RF signal processing semiconductor chip 33 mounted on and adhered to the digital baseband signal processing semiconductor chip 31 with an adhesive layer 34, a plurality of leads 35 connected to the baseband signal processing chip 31 and the RF signal processing semiconductor chip 33 by bonding wires 36, and a molded resin enveloper 37 which seals and encapsulates the mount plate 30, the semiconductor chips 31 and 33, the bonding wires 36, and inner sections of the shaped leads 35. Note, in Fig. 3A, only a contour of the molded resin enveloper 37 is shown by a phantom line for a simplicity of illustration.

As representatively shown in Fig. 3B, the digital baseband signal processing semiconductor chip 31 has an electrode pad 31A formed on a top surface thereof, and a bonding wire 36 is connected to the baseband signal processing semiconductor chip 31 at the corresponding electrode pad 31A. Similarly, the analog RF signal processing semiconductor chip 33 has an electrode pad 33A formed on a top surface thereof, and a bonding wire 36 is connected to the RF signal processing semiconductor chip 33 at the corresponding electrode pad 33A.

Also, as shown in Fig. 3A, a tuning wire 38 is suitably provided as an inductance element at the leads 35 of the baseband signal processing semiconductor chip 31, which are used for transmitting high frequency signals, to thereby improve an impedance characteristic in the leads 35 concerned.

In the above-mentioned GPS-signal receiver apparatus 10 of Fig. 1A and 1B, when the QFP type semiconductor package of Figs. 3A and 3B is substituted for both the RF signal processing unit 10C and the baseband signal processing unit 10E, and this substitution may contribute to downsizing of the wiring board of the GPS-signal receiver apparatus 10. However, this downsizing is insufficient in that the band pass filter unit 10A, the impedance matching circuit unit 10B and the band pass filter unit 10D must be individually and separately mounted on the wiring board, resulting in bulkiness of the GPS-signal receiver apparatus 10.

In the QFP type semiconductor package of Figs. 3A and 3B, the RF signal processing semiconductor chip 33 is susceptible to being influenced by high frequency noises, especially generated from the baseband signal processing semiconductor chip 31, because an active layer of the RF signal processing semiconductor chip 33, in which various elements such as transistors, capacitors, resistors, inductors and so on, are formed, is only covered with a part of the molded resin enveloper 37.

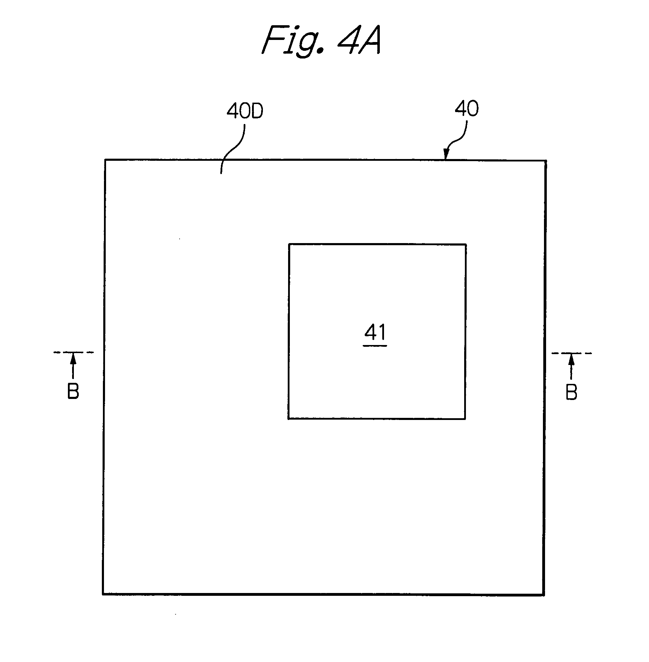

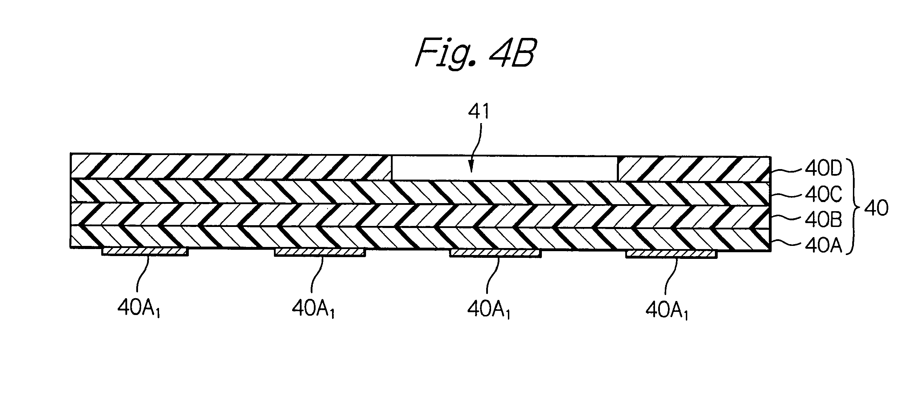

Next, with reference to Figs. 4A through 8A and Figs. 4B through 8B, a method for manufacturing a first embodiment of a system-in-package (SIP) type package according to the present invention, which is used as a GPS receiver apparatus, will be explained below.

Note, Figs. 4A through 8A are plan views for explaining the manufacturing method, and Figs. 4B through 8B are cross-sectional views taken along the B-B lines of Figs. 4A through 8A, respectively.

Referring to Figs. 4A and 4B, a multi-layered wiring board 40, which is called a package board or an interposer, is prepared. The multi-layered wiring board 40 includes four insulating layers: a lowermost insulating layer 40A, an intermediate insulating layer 40B, an intermediate insulating layer 40C, and an uppermost insulating layer 40D, which are stacked in order, and each of the insulating layers 40A, 40B, 40C and 40D may be composed of a suitable resin material such as epoxy resin.

Although not shown in Fig. 4B, each of the lowermost and intermediate insulating layers 40A, 40B and 40C has a wiring pattern layer formed on a top surface thereof, and a plurality of through holes formed therein to thereby establish electrical connections between the two adjacent wiring pattern layers. The wiring pattern layers and the through holes may be composed of a suitable metal material such as copper (Cu), and the formation of the wiring pattern layers and the through holes may be carried out by using a photolithography and etching process.

As shown in Fig. 4B, the lowermost insulating layer 40A has a plurality of electrode pads 40A₁ formed on a bottom surface thereof, and these electrode pads 40A₁ are suitably connected to the wiring pattern layer, formed on the top surface of the lowermost insulating layer 40A, through the intermediary of through holes (not shown) formed therein.

As shown in Figs. 4A and 4B, a recess 41 is formed in the uppermost insulating layer 40D, and a plurality of through holes (not shown) are formed in the uppermost insulating layer 40D by using a photolithography and etching process.

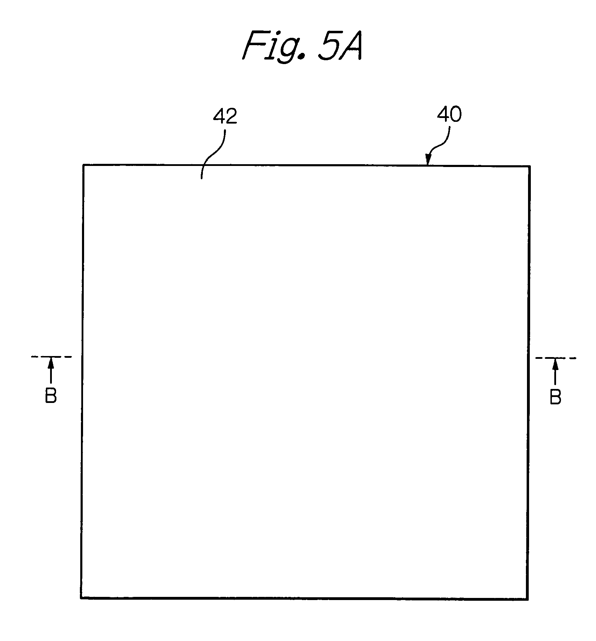

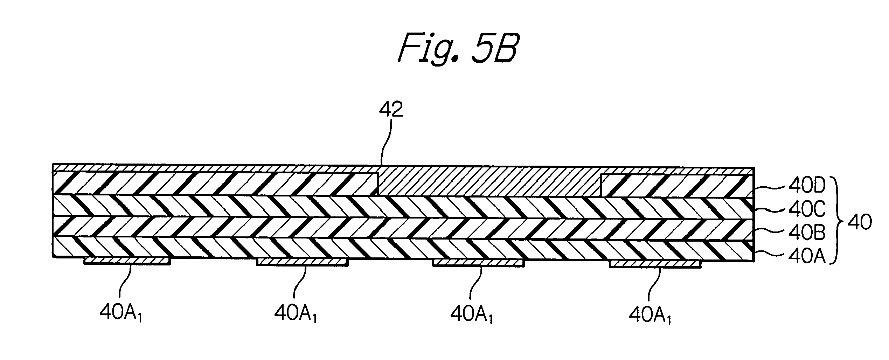

Next, referring to Figs. 5A and 5B, a copper (Cu) layer 42 is formed on the top surface of the uppermost insulating layer 40D by using a copper plating process, so that the recess 40D₁ is stuffed with copper. Note, in Fig. 5B, although the thickness of each of the insulating layers 40A, 40B, 40C and 40D is exaggeratedly illustrated, in reality, it is very thin so that the formation of the Cu layer 42 is substantially evenly carried out without the Cu layer 42 sagging at the recess 41.

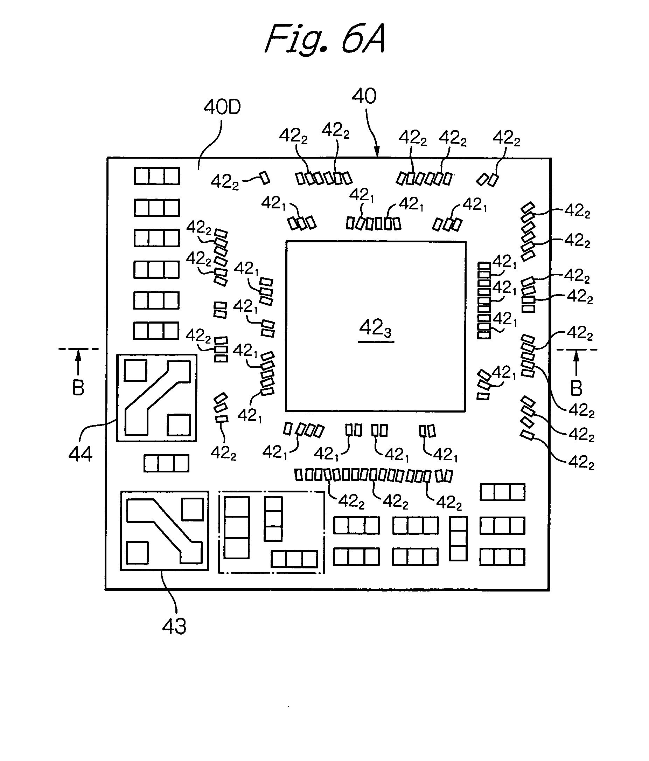

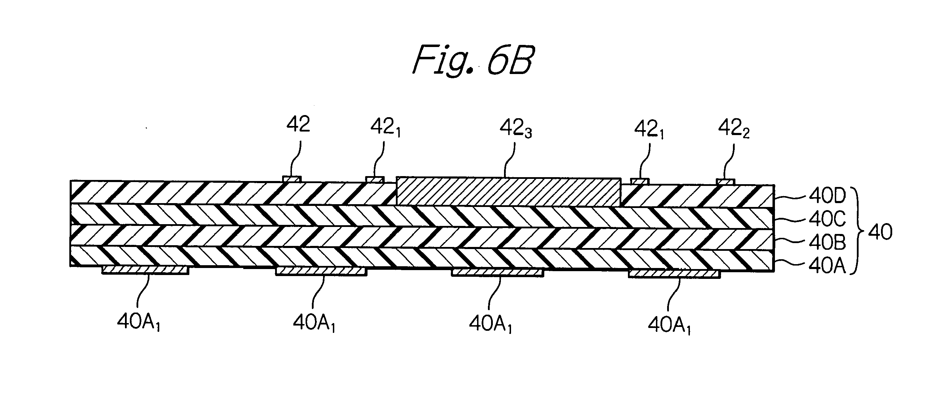

Next, referring to Figs. 6A and 6B, the Cu layer 42 (see: Figs. 5A and 5B) is patterned by using a photolithography and etching process, so that a plurality of electrode pads 42₁ and a plurality of electrode pads 42₂ are formed on the top surface of the uppermost insulating layer 40D, and so that a copper (Cu) layer section 42₃ is left as a ground layer at the rectangular recess 41. As shown in Fig. 6A, the electrode pads 42₁ are arranged so as to surround the Cu layer section or rectangular ground layer 42₃, and the electrode pads 42₂ are arranged along an outer periphery of the arrangement of the electrode pads 42₁.

Note, although a wiring pattern layer is further formed on the top surface of the uppermost insulating layer 40D by the aforesaid photolithography and etching process, it is not shown in Figs. 6A and 6B to avoid complexity of illustration.

Also, note, the wiring pattern layer formed on the top surface of the uppermost insulating layer 40D is suitably connected to the aforesaid through holes formed therein, to thereby establish electrical connections between the wiring pattern layer concerned and the electrode pads 40A₁ formed on the bottom surface of the lowermost insulating layer 40A.

Further, note, the electrode pads 42₁ and 42₂ are suitably connected to the wiring pattern layer concerned.

As shown in Fig. 6A, after the formation of the wiring pattern layer on the uppermost insulating layer 40D is completed, two band pass filter units 43 and 44 are mounted on the uppermost insulating layer 40D so as to be suitably connected to the wiring pattern layer concerned, and each of the band pass filter units 43 and 44 may be formed as a surface acoustic wave (SAW) type chip. Note, the band pass filter units 43 and 44 correspond to the band pass filter units 10A and 10D of the GPS-signal receiver apparatus 10 of Figs. 1A and 1B.

Also, an impedance matching circuit 45 is constituted by mounting and arranging various passive elements 45A and 45B on the uppermost insulating layer 40D, with the impedance matching circuit 45 being suitably connected to the wiring pattern layer (not shown) on the uppermost insulating layer 40D. For example, each of the passive elements 45A is formed as a capacitor chip, and each of the passive elements 45B is formed as an inductor chip. Note, the impedance matching circuit 45 corresponds to the impedance matching circuit unit 10B of the GPS-signal receiver apparatus 10 of Figs. 1A and 1B.

Further, various passive elements, representatively indicated by reference numeral 46, are mounted and arranged on the uppermost insulating layer 40D, if necessary, and are suitably connected to the wiring pattern layer (not shown) on the uppermost wiring layer 40D. A part of the passive elements 46 may be represented by a resistor chip, and another part of the passive elements may be represented by a capacitor chip. For example, a signal-strength conversion circuit is constituted by some of the passive elements 46.

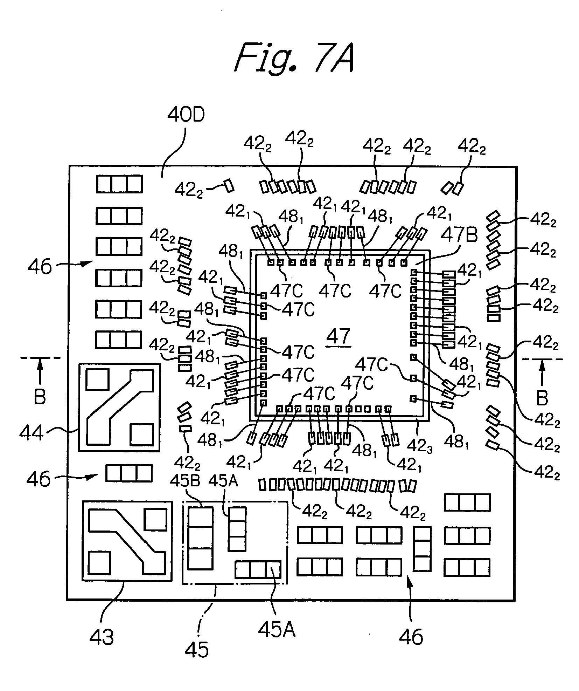

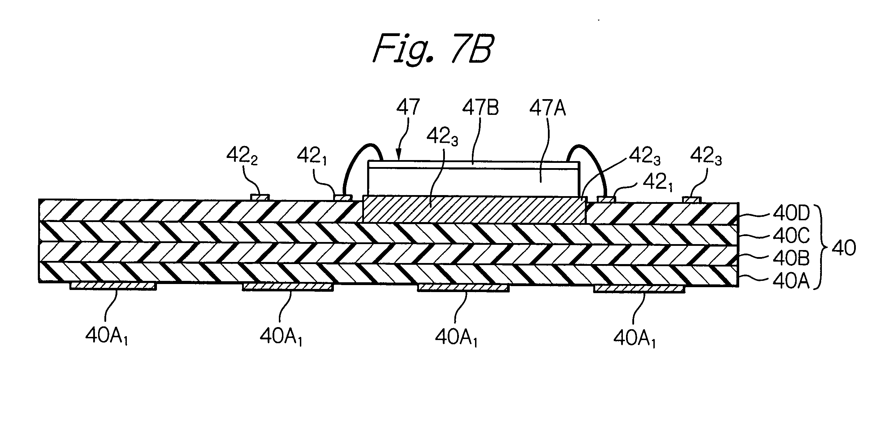

Next, referring to Figs. 7A and 7B, an analog rectangular semiconductor chip 47 is securely mounted on the rectangular ground layer 42₃ by using a suitable adhesive agent.

As shown in Fig. 7B, the RF signal processing semiconductor chip 47 includes a substrate 47A, and an active layer 47B formed on the substrate 47A, and the active layer 47B includes various elements, such as transistors, capacitors, resistors and so on formed therein. In short, the mounting of the RF signal processing semiconductor chip 47 on the ground layer 42₃ is carried out such that the active layer 47B is directed toward the upside.

Also, as shown in Fig. 7A, the rectangular RF signal processing semiconductor chip 47 has a plurality of electrode pads 47C which are formed on a surface of the active layer 47B so as to be arranged along the four sides thereof.

After the mounting of the RF signal processing semiconductor chip 47 on the ground layer 42₃ is completed, the electrode pads 47C are connected to the electrode pads 42₁, formed on the uppermost insulating layer 40D, with bonding wires 48₁ by using a wire bonding machine (not shown).

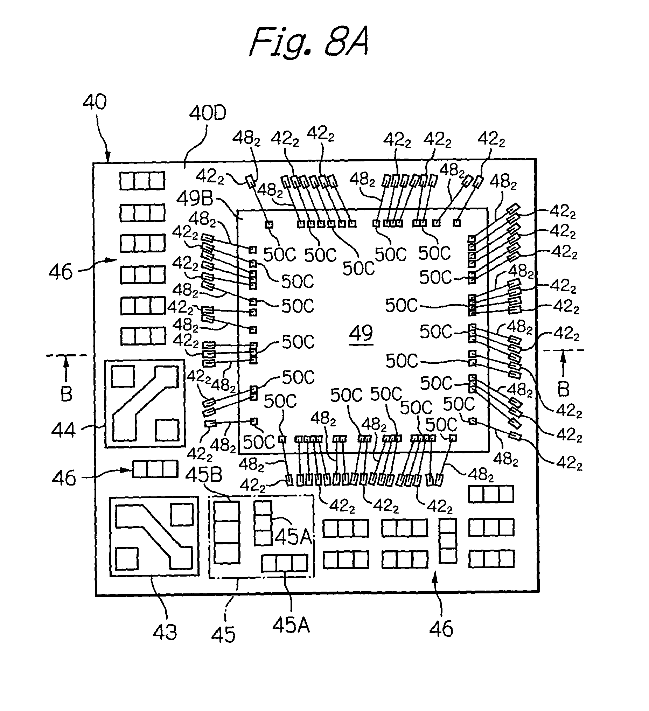

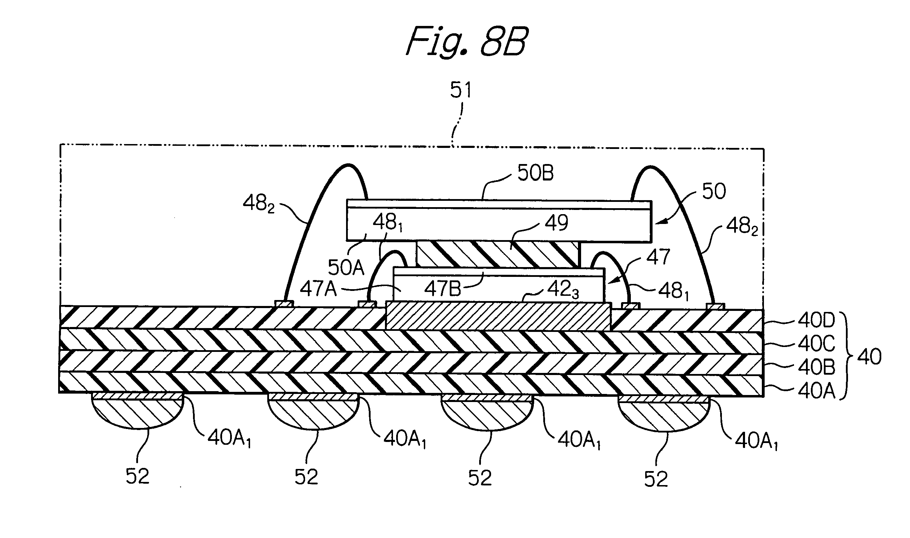

Next, referring to Figs. 8A and 8B, a spacer member 49, which may be made of a suitable resin material, is securely mounted on the RF signal processing semiconductor chip 47 by using a suitable adhesive agent, and a digital rectangular baseband signal processing semiconductor chip 50 having a larger size than that of the RF signal processing semiconductor chip 47 is securely mounted on the spacer member 49 by using a suitable adhesive agent. Of course, the spacer member 49 is provided for avoiding an interference between the bonding wires 48₂ and the baseband signal processing semiconductor chip 50.

As shown in Fig. 8B, the baseband signal processing semiconductor chip 50 includes a substrate 50A, and an active layer 50B formed on the substrate 50A, and the active layer 50B includes various elements, such as transistors, capacitors, resistors and so on formed therein. In short, the mounting of the baseband signal processing semiconductor chip 50 on the spacer member 49 is carried out such that the active layer 50B is directed toward the upside.

Also, as shown in Fig. 8A, the rectangular baseband signal processing semiconductor chip 50 has a plurality of electrode pads 50C which are formed on a surface of the active layer 50B so as to be arranged along the four sides thereof.

After the mounting of the baseband signal processing semiconductor chip 50 on the spacer member 49 is completed, the electrode pads 50C are connected to the electrode pads 42₂, formed on the uppermost insulating layer 40D, with bonding wires 48₂ by using the wire bonding machine (not shown).

Thereafter, all the elements, which are provided on the uppermost insulating layer 40D, are sealed with a molded resin enveloper 51, only a contour of which is shown by a phantom line in Fig. 8A for simplicity of illustration. Subsequently, as shown in Fig. 8B, a plurality of metal balls 52 are securely attached as electrode terminals to the electrode pads 40A₁ formed on the bottom surface of the lowermost insulating layer 40A, resulting in the production of the SIP type package according to the present invention. Namely, this SIP type package features a ball grid array (BGA) formed by the metal balls 52.

Note, the aforesaid signal-strength conversion circuit, which is explained with reference to Fig. 6A, is used to regulate the strength of a baseband signal to be input from the RF signal processing semiconductor chip 47 to the baseband signal processing semiconductor chip 50.

Although the SIP type package thus produced can operate in substantially the same manner as the GPS-signal receiver apparatus 10 of Figs. 1A and 1B, this package is considerably downsized in comparison with the GPS-signal receiver apparatus 10 of Figs. 1A and 1B, in that all the elements (43, 44, 45, 46, 47, 50, etc.) are integrated as one package.

Also, in the SIP type package of Figs. 8A and 8B, the ground layer 42₃ is coextended with respect to the RF signal processing semiconductor chip 47 so that a ground ability of the ground layer 47 is sufficiently fortified. Thus, a current flowing through the substrate 47A can be effectively drained out into the ground layer 42₃, whereby it is possible to stably maintain a high frequency characteristic of the RF signal processing semiconductor chip 47. On the other hand, the active layer 47B of the RF signal processing semiconductor chip 47 is covered with the substrate 50A of the baseband signal processing semiconductor chip 50, and an electric potential of the substrate 50A is relatively stable during an operation of the baseband signal processing semiconductor chip 50, so that the substrate 50A serves as an effective electromagnetic shield. As a result, not only can a stable operation of the RF signal processing semiconductor chip 47 be ensured, but also the RF signal processing semiconductor chip 47 can be effectively protected from high frequency noises.

During an operation of the baseband signal processing semiconductor chip 50, high frequency noises are generated from the active layer 50B thereof. Thus, when the baseband signal processing semiconductor chip 50 is stacked on the RF signal processing semiconductor chip 47 (see: Fig. 8B), the RF signal processing semiconductor chip 47 may be influenced by the high frequency noises generated from the active layer 50B.

Nevertheless, according to an experiment carried out by the inventor, it was found that the RF signal processing semiconductor chip 47 could not be substantially influenced by the high frequency noises generated from the active layer 50B.

In the experiment, a first group of samples, in each of which a baseband signal processing semiconductor chip (50) was stacked on a spacer (49) mounted on an RF signal processing semiconductor chip (47) (see: Fig. 8B), were prepared, and a sensitivity characteristic of the RF signal processing semiconductor chip (47), represented by a signal/noise ratio (SNR), was measured with respect to each of the sample included in the first group. On the other hand, a second group of samples, in each of which an RF signal processing semiconductor chip (47) was directly stacked on a baseband signal processing semiconductor chip (50), and a sensitivity characteristic of the RF signal processing semiconductor chip (47), represented by a signal/noise ratio (SNR), was measured with respect to each of the samples included in the second group. In the measurements, the AUTONOMOUS mode was used, and the input/output (I/0) voltage was 2.9 V. Also, the strength of a GPS signal was set in -130 dBm, but it were variable between a maximum value and a minimum value. The measurements ware carried out at the maximum and minimum values of the strength of the GPS signal.

The measured results are shown in the following tables:

| | FIRST GROUP | |
|---|---|---|
| | SNR (max) | SNR (min) |
| AVERAGE VALUE | 38.1dB | 37.3B |

| | SECOND GROUP | |
|---|---|---|
| | SNR (max) | SNR (min) |
| AVERAGE VALUE | 35.4dB | 34.5dB |

As shown in these tables, the results measured on the first group of samples were superior to the results measured on the second group of samples by approximately 3dB. This means that the substrate 50A of the baseband signal processing semiconductor chip 50 functions as the effective electromagnetic shield for protecting the RF signal processing semiconductor chip 47.

As already explained, in the prior art of Figs. 1A and 1B, when the plurality of GPS-signal receiver apparatuses 10 are produced, it is necessary to individually adjust the impedance matching units 10B. On the contrary, when a plurality of SIP type packages are manufactured in accordance with the present invention, it is unnecessary to individually adjust the impedance matching circuits 45, because it is possible to previously determine optimum values of the capacitor 45A and the inductors 45B for forming the impedance matching circuits 45. Similarly, it is unnecessary to individually adjust the above-mentioned signal-strength conversion circuits, explained with reference to Fig. 6A, because it is possible to previously determine optimum values of the passive elements, such as capacitors, resistors and so on, for forming the signal-strength conversion circuits.

In the above-mentioned embodiment of Figs. 8A and 8B, although the baseband signal processing semiconductor chip 50 has a wider size than that of the RF signal processing semiconductor chip 47, the latter may be wider than the former, if necessary. In this case, if there is no interference between the bonding wires 48₂ and the baseband signal processing semiconductor chip 50, the spacer member 49 could be omitted. Namely, the baseband signal processing semiconductor chip 50 may be directly adhered to the RF signal processing semiconductor chip 47 without using the spacer member 49.

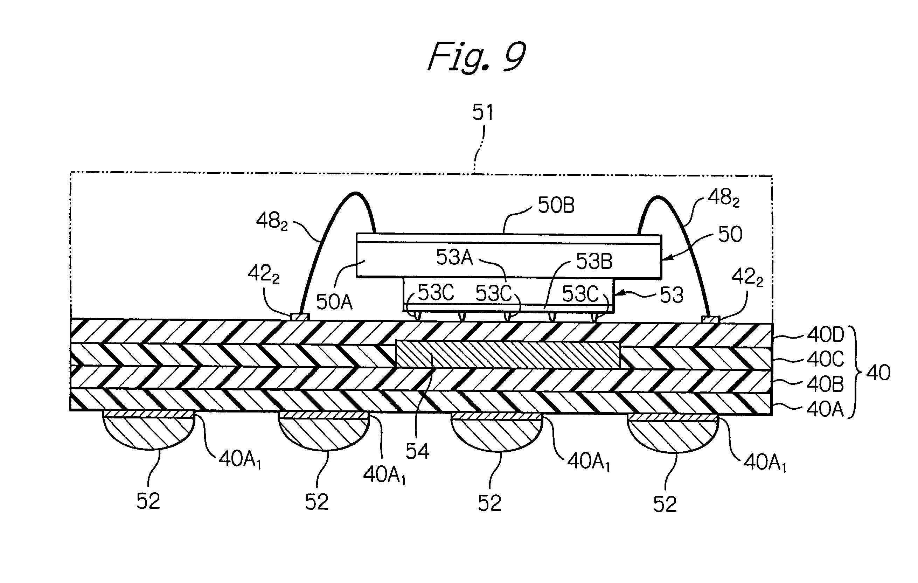

With reference to Fig. 9 which corresponds to Fig. 8A, a modification of the aforesaid embodiment of the SIP type package according to the present invention is shown.

In the modification, a flip-chip (FC) type analog RF signal processing semiconductor chip 53 is substituted for the RF signal processing semiconductor chip 47, and includes a substrate 53A, and an active layer 53B formed on the substrate 53A. The FC type analog RF signal processing semiconductor chip 53 has a plurality of metal bumps 53C which are securely attached as electrode terminals to a surface of the active layer 53B.

Also, in the modification, the ground layer 42₃ is omitted from the uppermost insulating layer 40D, and a ground layer 54 is formed instead in the intermediate insulating layer 40C just below the uppermost insulating layer 40D. Similar to the formation of the ground layer 42₃, the formation of the ground layer 54 is carried out at the same time when the wiring pattern layer (not shown) is formed on the intermediate insulating layer 40C.

On the other hand, the wiring pattern layer formed on the uppermost insulating layer 40D has a plurality of electrode pads (not shown) which are arranged so as to have a mirror image relationship with respect to the arrangement of the metal bumps 53C. Namely, the FC type RF signal processing semiconductor chip 53 is flipped over and mounted on the uppermost insulating layer 40D such that the metal bumps are contacted with and bounded on the respective electrode pads.

Similar to the embodiment of Figs. 8A and 8B, in the modification of Fig. 9, the ground layer 54 is coextended with respect to the FC type RF signal processing semiconductor chip 53 so that a ground ability of the ground layer 54 is sufficiently fortified. Also, the substrate 50A of the baseband signal processing semiconductor chip 50 serves as an effective electromagnetic shield. Thus, not only can a stable operation of the FC type RF signal processing semiconductor chip 53 be ensured, but also the FC type RF signal processing semiconductor chip 53 can be effectively protected from high frequency noises.

Finally, it will be understood by those skilled in the art that the foregoing description is of preferred embodiments of the method and the devices, and that various changes and modifications may be made to the present invention without departing from the spirit and scope thereof.

## Claims

1. A semiconductor package comprising:
a wiring board (40) having a ground layer (42₃, 54) formed therein;
an analog semiconductor chip (47, 53) provided on or above said ground layer; and
a digital semiconductor chip (50) provided on or above said analog semiconductor chip such that a substrate (50A) of said digital semiconductor chip is directed toward said analog semiconductor chip.

2. The semiconductor package as set forth in claim 1,
wherein said analog semiconductor chip is formed as a radio frequency signal processing semiconductor chip (47, 53), and said digital semiconductor chip is formed as a baseband signal processing semiconductor chip (50).

3. The semiconductor package as set forth in claim 1,
wherein said ground layer (42₃, 54) is coextended with respect to said analog semiconductor chip (47, 53).

4. The semiconductor package as set forth in claim 1,
wherein an active layer (47B) of said analog semiconductor chip (47) is directed toward an upside, and an active layer (50B) of said digital semiconductor chip (50) is directed toward the upside.

5. The semiconductor package as set forth in claim 4,
wherein said analog semiconductor chip (47) and said digital semiconductor chip (50) are connected to a wiring pattern layer, formed on said wiring board (40), with a plurality of conductive wires (48₁, 48₂).

6. The semiconductor package as set forth in claim 1,
wherein an active layer (53B) of said analog semiconductor chip (53) is directed toward a downside, and an active layer (50B) of said digital semiconductor chip (50) is directed toward an upside.

7. The semiconductor package as set forth in claim 6,
wherein said digital semiconductor chip (50) is mounted on a substrate (53A) of said analog semiconductor chip (53).

8. The semiconductor package as set forth in claim 6,
wherein said analog semiconductor chip has a plurality of metal bumps (53C) provided on the active layer (53B) thereof, and is connected to a wiring pattern layer, formed on said wiring board (40), with said metal bumps, and wherein said digital semiconductor chip (50) is connected to said wiring pattern layer with a plurality of conductive wires (48₂).

9. The semiconductor package as set forth in claim 1,
wherein said digital semiconductor chip (50) features a wider size than that of the analog semiconductor chip (47, 53).

10. The semiconductor package as set forth in claim 9, further comprising a spacer unit (49) provided between said analog semiconductor chip (47) and said digital semiconductor chip (50).

11. The semiconductor package as set forth in claim 1, further comprising:
an impedance matching circuit (45) provided on said wiring board for said analog semiconductor chip (47, 53); and
a molded resin enveloper (51) encapsulating said analog and digital semiconductor chips and said impedance matching circuit.

12. The semiconductor package as set forth in claim 1, further comprising:
a band pass filter (43, 44) provided on said wiring board for said analog semiconductor chip (47, 53); and
a molded resin enveloper (51) encapsulating said analog and digital semiconductor chips and said band pass filter.

13. The semiconductor package as set forth in claim 1, further comprising a plurality of metal balls (52) securely attached as electrode terminals to respective electrode pads (40A₁) formed on a bottom surface of the wiring board (40).

14. The semiconductor package as set forth in claim 1,
wherein said wiring board is formed as a multi-layered wiring board (40) including at least a lowermost insulating layer (40A), an intermediate insulating layer (40B, 40C), and an uppermost insulating layer (40D).

15. The semiconductor package as set forth in claim 14,
wherein an active layer (47B) of said analog semiconductor chip (47) is directed toward an upside, and an active layer (50B) of said digital semiconductor chip (50) is directed toward the upside, said ground layer (42₃) being formed in said uppermost insulating layer (40D) so that said analog semiconductor chip (47) is positioned on said ground layer.

16. The semiconductor package as set forth in claim 14,
wherein an active layer (53B) of said analog semiconductor chip (53) is directed toward a downside, and an active layer (50B) of said digital semiconductor chip (50) is directed toward an upside, said ground layer (54) being formed in said intermediate insulating layer (40B, 40C) just below said uppermost insulating layer so that said analog semiconductor chip (53) is positioned above said ground layer.

17. A method for manufacturing a semiconductor package comprising:
preparing a wiring board (40);
forming a ground layer (42₃, 54) in said wiring board;
providing an analog semiconductor chip (47, 53) on or above said ground layer; and
providing a digital semiconductor chip (50) on or above said analog semiconductor chip such that a substrate (50A) of said digital semiconductor chip is directed toward said analog semiconductor chip.

18. The method as set forth in claim 17, wherein said analog semiconductor chip is formed as a radio frequency signal processing semiconductor chip (47, 53), and said digital semiconductor chip is formed as a baseband signal processing semiconductor chip (50).

19. The method as set forth in claim 17, wherein the formation of said ground layer (42₃, 54) is carried out so that said ground layer is coextended with respect to said analog semiconductor chip (47, 53).
